# EUROPÄISCHE PATENTSCHRIFT

(11) **EP 0 506 174 B1**
(45) Veröffentlichungstag und Bekanntmachung des Hinweises auf die Patenterteilung: **11.09.1996**
(21) Anmeldenummer: 92200756.2
(22) Anmeldetag: 17.03.1992
(51) Int. Cl.: H03F 3/45

(54) **Integrierte Schaltungsanordnung mit einem Differenzverstärker**
Integrated circuit device comprising a differential amplifier
Dispositif à circuit intégré comprenant un amplificateur différentiel

(30) Priorität: 26.03.1991 DE 4109893
(43) Veröffentlichungstag der Anmeldung: 30.09.1992
(73) Patentinhaber: Philips Patentverwaltung GmbH, 22335 Hamburg (DE); Philips Electronics N.V., 5621 BA Eindhoven (NL)
(72) Erfinder: Schmidt, Christoph, Dipl.-Ing. (FH), W-8551 Igensdorf (DE)
(74) Vertreter: Volmer, Georg, Dipl.-Ing.

(56) Entgegenhaltungen:
- EP-A- 0 171 095
- US-A- 3 564 439
- US-A- 3 946 325

## Beschreibung

Integrierte Schaltungsanordnung mit einem Differenzverstärker

Die Erfindung bezieht sich auf eine integrierte Schaltungsanordnung mit einem Differenzverstärker, dessen Ausgänge jeweils mit einer Arbeitswiderstandsanordnung und jeweils mit einem als Impedanzwandler geschalteten Transistor und dessen Steuereingang mit einer Stromquelle gekoppelt sind.

Eine solche integrierte Schaltungsanordnung, die einen Differenzverstärker mit an seinen Ausgängen angeschlossenen Impedanzwandlern enthält, wird insbesondere in einer Schaltung für hohe Frequenzen, beispielsweise im GHz-Bereich, verwendet. Aus dem ITG-Fachbericht 103, Mikroelektronik für die Informationstechnik, Vorträge der ITG-Fachtagung vom 03. bis 05.10.1988 in Berlin, "Grundschaltungen für die optische Breitbandkommunikation bis 10 GBit/s mit einem einfachen selbstjustierenden SI-Bipolarprozeß - Prozeßcharakterisierung und Schaltungssimulationen", H.-U. Schreiber und U. Langmann, VDE-Verlag, Seiten 21 bis 26, ist ein 2:1-Multiplexer bekannt, der in seinem Ausgangskreis einen Differenzverstärker mit zwei Bipolartransistoren enthält. Die Emitter der beiden Transistoren der Differenzverstärker sind verbunden und bilden den Steuereingang des Differenzverstärkers, der an eine Stromquelle angeschlossen ist. Eine solche Stromquelle wird üblicherweise mittels eines Transistors realisiert. Den Basisanschlüssen der beiden Transistoren des Differenzverstärkers wird das Eingangssignal zugeführt. Mit dem Kollektor jedes Transistors (Ausgänge des Differenzverstärkers) sind jeweils eine Arbeitswiderstandsanordnung, die aus einem Widerstand besteht, und jeweils zwei in Reihe geschaltete als Emitterfolger (Impedanzwandler) geschaltete weitere Bipolartransistoren verbunden. Aufgrund der Stromquelle am Steuereingang des Differenzverstärkers sind die Kollektorströme des Differenzverstärkers auch bei einer Temperaturänderung weitgehend konstant. Wegen der konstanten Kollektorströme ist auch die Gleichspannung an den Kollektoren weitgehend konstant. Die Basis-EmitterSpannung eines Emitterfolgers ist abhängig von der Temperatur. Bei einer Temperaturänderung ändert sich die Ausgangsspannung der integrierten Schaltungsanordnung. Diese Änderung ist bedingt durch eine Änderung der Basis-Emitter-Spannung der Emitterfolger. Bei einer Basis-EmitterSpannungsänderung eines Emitterfolgers von ca. - 2 mV/K ergibt sich für einen Bereich von - 20°C bis 80 °C eine Spannungsänderung am Ausgang des Differenzverstärkers von - 200 mV pro Emitterfolger. Durch die Änderung der Ausgangsspannung bei Temperaturänderungen kann es in nachfolgenden Schaltungen zu unerwünschten Betriebsbedingungen kommen.

Der Erfindung liegt daher die Aufgabe zugrunde, eine integrierte Schaltungsanordnung mit einem Differenzverstärker zu schaffen, die über einen großen Temperaturbereich eineweitgehend konstante Ausgangsspannung erzeugt.

Diese Aufgabe wird bei einer integrierten Schaltungsanordnung mit einem Differenzverstärker der eingangs genannten Art dadurch gelöst,
daß ein Kompensations-Differenzverstärker zur Überlagerung seiner Ausgangsströme mit den jeweiligen Ausgangsströmen des Differenzverstärkers zur Kompensation von Spannungsveränderungen in den jeweiligen Arbeitswiderstandsanordnungen bei einer Temperaturänderung vorgesehen ist,
daß die Anschlüsse des Differenzeingangs des Kompensations-Differenzverstärkers jeweils mit einem ersten Bezugspotential und der Steuereingang des Kompensations-Differenzverstärkers mit einem zweiten Bezugspotential gekoppelt sind zur gleichmäßigen Verteilung des dem Steuereingang des Kompensations-Differenzverstärkers zugeführten Stomes auf die Ausgänge des Kompensations-Differenzverstärkers, und
daß entweder mit den Anschlüssen des Differenzeingangs oder mit dem Steuereingang des Kompensatios-Differenzverstärkers eine Widerstandsanordnung gekoppelt ist.

Eine Temperaturänderung bewirkt eine Spannungsänderung zwischen den gekoppelten Anschlüssen des Differenzeingangs und dem Steuereingang der in dem Kompensations-Differenzverstärker enthaltenen Transistoren. Ebenso verändern sich die Ausgangsströme des Kompensations-Differenzverstärkers. Werden in dem Kompensations-Differenzverstärker Bipolartransistoren verwendet, so ändert sich bei einer Temperaturänderung die Basis-Emitter-Spannung der Transistoren und der jeweilige Kollektorstrom. Die Kollektorströme des Kompensations-Differenzverstärkers werden den jeweiligen Kollektorströmen des Differenzverstärkers überlagert. Ist mit jedem Ausgang des Differenzverstärkers ein als Impedanzwandler geschalteter Bipolartransistor (Emitterfolger) verbunden, so verändert sich bei einer Temperaturänderung dessen Basis-Emitter-Spannung. Der von dem Kompensations-Differenzverstärker hervorgerufene veränderte Kollektorstrom bei einer Temperaturänderung ruft in den jeweiligen Arbeitswiderstandsanordnungen eine entgegengesetzte Spannung hervor, so daß sich eine Ausgangsspannung einstellt, die der Ausgangsspannung ohne Temperaturänderung weitgehend entspricht. Die integrierte Schaltungsanordnung kann auch mit Feldeffekttransistoren realisiert werden.

Die Anschlüsse des Differenzeingangs des Kompensations-Differenzverstärkers können direkt mit dem ersten Bezugspotential verbunden sein, wenn keine Widerstands anordnung an den Eingängen vorgesehen ist. Es kann jedoch auch eine geeignete Voreinstellung durch zwei vorgeschaltete Widerstände vorgenommen werden. Hierbei ist vorgesehen, daß zwischen dem Steuereingang des Kompensations-Differenzverstärkers und dem zweiten Bezugspotential eine Widerstandsanordnung angeordnet ist, daß mit den Anschlüssen des Differenzeingangs des Kompensations-Differenzverstärkers Anschlüsse eines ersten und zweiten Widerstandes gekoppelt sind, daß der andere Anschluß des ersten Widerstandes an dem ersten Bezugspotential liegt und daß der andere Anschluß des zweiten Widerstandes mit einem dritten Bezugspotential gekoppelt ist. Das erste und zweite Bezugspotential sollten aus Vereinfachungsgründen gleich sein. Das dritte Bezugspotential kann der Masseanschluß sein.

Eine einfache Widerstandsanordnung ergibt sich, wenn diese einen dritten Widerstand enthält. Bei einer Realisierung des Kompensations-Differenzverstärkers mit Bipolartransistoren kann der dritte Widerstand einerseits mit den Emittern der beiden Bipolartransistoren und andererseits mit dem zweiten Bezugspotential verbunden sein.

Bei bestimmten Anwendungen der integrierten Schaltungsanordnung können vorbestimmte von der Temperatur abhängige Ausgangsspannungen gewünscht sein. Eine solche andere temperaturabhängige Ausgangsspannung läßt sich erreichen, indem der erste und/oder der zweite Widerstand eine vorbestimmte Temperaturabhängigkeit aufweisen. Eine weitere Möglichkeit ergibt sich, wenn der dritte Widerstand eine vorbestimmte Temperaturabhängigkeit aufweist.

Eine weitere Impedanzerniedrigung am Ausgang der integrierten Schaltungsanordnung läßt sich erreichen, indem in Reihe zu jedem als Impedanzwandler geschalteten Transistor wenigstens ein weiterer als Impedanzwandler geschalteter Transistor angeordnet ist. Falls dieser weitere Transistor ein Bipolartransistor ist, ergibt sich bei einer Temperaturänderung eine veränderte Basis-Emitter-Spannung. Diese zusätzliche Spannungsänderung, kann kompensiert werden, wenn vorgesehen ist, daß zwischen dem zweiten Widerstand und den Anschlüssen des Differenzeingangs des Kompensations-Differenzverstärkers wenigstens eine Diodenanordnung geschaltet ist. Diese Diodenanordnung ist ebenfalls temperaturabhängig und bewirkt zusätzliche Kompensationsströme im Kompensations-Differenzverstärker. Eine solche Diodenanordnung kann einen als Diode geschalteten Transistor enthalten. Es können in der Diodenanordnung weitere in Reihe geschaltete Dioden zur Temperaturkompensation weiterer Impedanzwandler vorhanden sein.

Eine andere temperaturabhängige Ausgangsspannung läßt sich erreichen, wenn die Transistoren des Kompensations-Differenzverstärkers andere geometrische Abmessungen als die als Impedanzwandler geschalteten Transistoren aufweisen.

Die Werte der Arbeitswiderstandsanordnung und die Werte der Transistoren des Differenzverstärkers hängen von der gewünschten Verstärkung ab. Es kann vorkommen, daß die Widerstandswerte der Arbeitswiderstandsanordnungen so groß sind, daß sich eine überkompensation der Ausgangsspannung ergibt, d.h., daß eine gegensätzliche Ausgangsspannungsänderung bei einer Temperaturänderung erfolgt. Um dies zu vermeiden ist vorgesehen, daß jede Arbeitswiderstandsanordnung aus einem vierten und fünften Widerstand besteht, die in Reihe geschaltet sind und an deren gemeinsamen Verbindungspunkt die Ausgänge des Kompensations-Differenzverstärkers angeschlossen sind. Die beiden Widerstände müssen so gewählt werden, daß genau die durch die Temperaturänderung bedingte Spannungsänderung kompensiert wird.

Ein Ausführungsbeispiel der Erfindung wird nachstehend an hand der Figuren näher erläutert. Es zeigen:
Fig. 1 eine zu integrierende Schaltungsanordnung mit einem Differenzverstärker und einem Kompensations-Differenzverstärker zur Temperaturkompensation und
Fig. 2 zwei in der Fig. 1 für den Differenzverstärker zu verwendende Arbeitswiderstandsanordnungen.

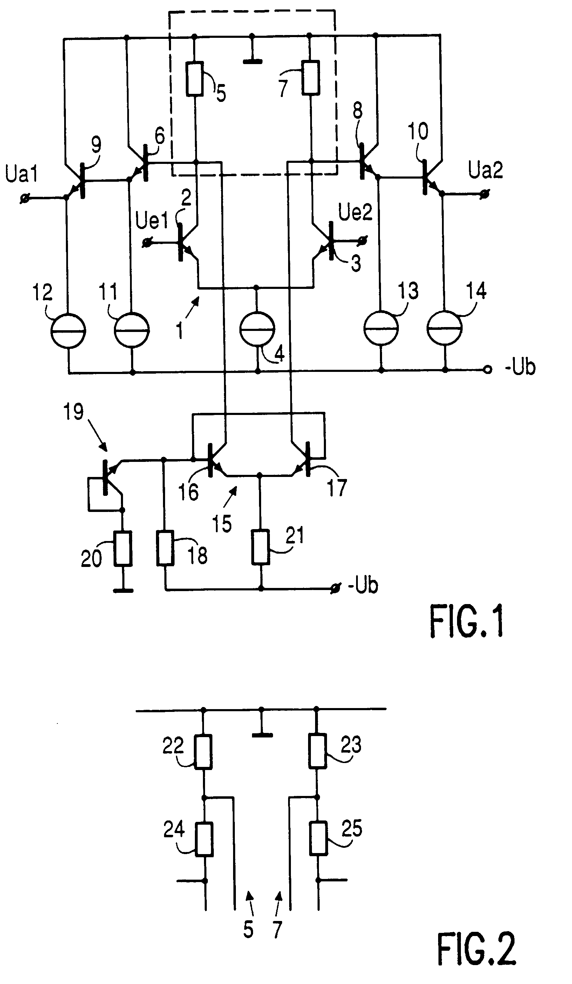

Die in Fig. 1 dargestellte zu integrierende Schaltungsanordnung enthält einen Differenzverstärker 1 mit zwei Transistoren 2 und 3. Die beiden Transistoren 2 und 3 des Differenzverstärkers 1 und die folgenden in der Figurenbeschreibung aufgeführten Transistoren stellen NPN-Bipolartransistoren dar. Die beiden Emitter der Transistoren 2 und 3 sind miteinander verbunden und bilden einen Steuereingang, mit dem ein erster Anschluß einer Stromquelle 4 verbunden ist. Die Eingänge des Differenzverstärkers 1 bilden die Basisanschlüsse der Transistoren 2 und 3. Der Basis des Transistors 2 wird eine Eingangsspannung Uel und der Basis des Transistors 3 eine Eingangsspannung Ue2 zugeführt. Die Ausgänge des Differenzverstärkers 1 bilden die jeweiligen Kollektoranschlüsse der Transistoren 2 und 3. Der Kollektor des Transistors 2 weist eine Verbindung mit einem ersten Anschluß einer Arbeitswiderstandsanordnung 5 und der Basis eines Transistors 6 auf. Der Kollektor des Transistors 3 bildet einen gemeinsamen Knoten mit einem ersten Anschluß einer weiteren Arbeitswiderstandsanordnung 7 und der Basis eines Transistors 8. Die Arbeitswiderstandsanordnungen 5 und 7 werden durch Widerstände realisiert. Die jeweiligen zweiten Anschlüsse der Arbeitswiderstandsanordnungen 5 und 7 sind mit Masse verbunden.

Die Transistoren 6 und 8 sind mit jeweils weiteren Transistoren 9 und 10 in Reihe geschaltet. Die Transistoren 6, 8, 9 und 10 sind als Emitterfolger geschaltet und dienen zur Impedanzwandlung. Die Kollektoren der Transistoren 6, 8, 9 und 10 sind jeweils mit Masse verbunden. Der Emitter des Transistors 6 ist einerseits an die Basis des Transistors 9 und andererseits an den ersten Anschluß einer Stromquelle 11 angeschlossen. Der Emitter des Transistors 9 liefert eine Ausgangsspannung Ua1 und weist eine Verbindung mit einem ersten Anschluß einer Stromquelle 12 auf. Der Emitter des Transistors 8 ist an die Basis des Transistors 10 und an einen ersten Anschluß einer Stromquelle 13 angeschlossen. Der Emitter des Transistors 10 liefert eine zweite Ausgangsspannung Ua2 und ist mit einem ersten Anschluß einer Stromquelle 14 verbunden. Die zweiten Anschlüsse der Stromquellen 4, 11, 12, 13 und 14 sind mit einer Versorgungsspannung -Ub verbunden.

Die Arbeitswiderstandsanordnungen 5 und 7 und die Transistoren 2 und 3 des Differenzverstärkers 1 sind so gewählt, daß eine bestimmte Verstärkung mit der Schaltungsanordnung erzielt wird. Verändert sich die Temperatur, so verändern sich die Basis-Emitter-Spannungen der Transistoren 6, 8, 9 und 10. Die Kollektorströme der Transistoren 2 und 3 bleiben auch bei einer Temperaturänderung weitgehend konstant, da die Kollektorströme im wesentlichen von der Stromquelle 4 abgeleitet sind. Die bei einer Temperaturänderung hervorgerufene Veränderung der Basis-Emitter-Spannungen der Transistoren 6, 8, 9 und 10 verändert die Ausgangsspannungen Ua1 und Ua2.

Zur Kompensation der temperaturbedingten Änderungen der Ausgangsspannungen Ua1 und Ua2 ist ein Kompensations-Differenzverstärker 15 vorgesehen. Der Kompensations-Differenzverstärker 15 enthält zwei Transistoren 16 und 17, deren Emitter miteinander verbunden sind und einen Steuereingang darstellen. Die Basisanschlüsse der beiden Transistoren 16 und 17 stellen die Eingänge des Kompensations-Differenzverstärkers 15 dar. Die Basisanschlüsse der Transistoren 16 und 17 sind untereinander, mit einem ersten Anschluß eines ersten Widerstandes 18 und mit einer Diodenanordnung 19 verbunden. Die Diodenanordnung enthält einen als Diode geschalteten Transistor, dessen Emitter mit dem ersten Anschluß des ersten Widerstandes 18 verbunden ist. Der Kollektor und die Basis des in der Diodenanordnung 19 enthaltenen Transistors ist an den ersten Anschluß eines zweiten Widerstandes 20 angeschlossen. Der zweite Anschluß des zweiten Widerstandes 20 liegt an Masse. Der Steuereingang des Kompensations-Differenzverstärkers 15 ist mit einem ersten Anschluß eines dritten Widerstandes 21 verbunden. Der zweite Anschluß des ersten Widerstandes 18 und der zweite Anschluß des dritten Widerstandes 21 ist an die Versorgungsspannung -Ub gelegt.

Bei einer Temperaturänderung verändern sich die BasisEmitter-Spannungen und die Kollektorströme der Transistoren 16 und 17. Diese Kollektorströme überlagern sich jeweils den Kollektorströmen der Transistoren 2 und 3 des Differenzverstärkers 1. Hierdurch ergibt sich an den Arbeitswiderstandsanordnungen 5 und 7 eine veränderte Spannung, die der Spannungsänderung an den Basis-Emitter-Spannungen der Transistoren 6 und 9 bzw. 8 und 10 entgegenwirkt. Mit den Transistoren 16 und 17 des Kompensations-Differenzverstärkers 15 kann in der Regel eine Kompensation der Basis-Emitter-Spannungsänderung der Transistoren 6 und 8 erreicht werden. Zur Kompensation der weiteren Basis-Emitter-Spannungsänderung der Transistoren 9 und 10 ist die Diodenanordnung 19 vorgesehen. Somit läßt sich mit Hilfe des Kompensations-Differenzverstärkers 15 und der Diodenanordnung 19 eine weitgehende Kompensation der Basis-Emitter-Spannungsänderungen der Transistoren 6, 8, 9 und 10 bei einer Temperaturänderung erreichen.

Bei bestimmten Anwendungsfällen ist außerdem eine bestimmte Abhängigkeit der Ausgangsspannungen Ua1 und Ua2 von der Temperatur gewünscht. Diese Abhängigkeiten können mit Hilfe der Widerstände 18, 20 und 21 erreicht werden, wenn diese eine vorbestimmte Temperaturabhängigkeit aufweisen. Ein weiterer zusätzlicher Effekt kann erreicht werden, wenn die Transistoren 16 und 17 des Kompensations-Differenzverstärkers 15 andere geometrische Abmessungen als die Transistoren 2 und 3 des Differenzverstärkers 1 aufweisen.

Wie oben erwähnt, werden die Arbeitswiderstandsanordnungen 5 und 7 und die Transistoren 2 und 3 so dimensioniert, daß eine bestimmte Verstärkung erzielt werden kann. Hierbei kann es vorkommen, daß die Arbeitswiderstandsanordnungen 5 und 7 solche Widerstandswerte aufweisen, daß eine Überkompensation bei einer Temperaturänderung erfolgt. Um einer solchen Überkompensation entgegenzuwirken, sind die Widerstände in den Arbeitswiderstandsanordnungen 5 und 7 durch jeweils zwei vierte Widerstände 22 und 23 und zwei fünfte Widerstände 24 und 25 realisiert. Der erste Anschluß des fünften Widerstandes 24 ist mit der Basis des Transistors 6 und dem Kollektor des Transistors 2 und der zweite Anschluß des fünften Widerstandes 24 ist mit dem Kollektor des Transistors 16 und dem ersten Anschluß des vierten Widerstandes 22 verbunden. Der erste Anschluß des fünften Widerstandes 25 ist an die Basis des Transistors 8 und an den Kollektor des Transistors 3 und der zweite Anschluß des fünften Widerstandes 25 ist an den Kollektor des Transistors 17 und an den ersten Anschluß des vierten Widerstandes 23 angeschlossen. Die zweiten Anschlüsse der vierten Widerstände 22 und 23 sind an Masse gelegt. Die veränderten Kollektorströme des Kompensations-Differenzverstärkerz erzeugen bei einer Tempersaturänderung eine Spannungsänderung in den Arbeitswiderstandsanordnungen 5 und 7. Diese Spannungsänderung wird bei der Anordnung nach der Fig. 2 durch die Widerstände 22 und 23 bestimmt.

## Patentansprüche

1. Integrierte Schaltungsanordnung mit einem Differenzverstärker (1), der einen Differenzeingang (Uₑ₁, Uₑ₂) und einen Steuereingang hat, und dessen Ausgänge jeweils mit einer Arbeitswiderstandsanordnung (5, 7) und jeweils mit einem als Impedanzwandler geschalteten Transistor (6, 8) und dessen Steuereingang mit einer Stromquelle (4) gekoppelt sind,
dadurch gekennzeichnet,
daß ein Kompensations-Differenzverstärker (15) zur Überlagerung seiner Ausgangsströme mit den jeweiligen Ausgangsströmen des Differenzverstärkers (1) zur Kompensation von Spannungsveränderungen in den jeweiligen Arbeitswiderstandsanordnungen (5, 7) bei einer Temperaturänderung vorgesehen ist,
daß die Anschlüsse des Differenzeingangs des Kompensations-Differenzverstärkers (15) jeweils mit einem ersten Bezugspotential und der Steuereingang des Kompensations-Differenzverstärkers (15) mit einem zweiten Bezugspotential gekoppelt sind zur gleichmäßigen Verteilung des dem Steuereingang des Kompensations-Differenzverstärkers (15) zugeführten Stomes auf die Ausgänge des Kompensations-Differenzverstärkers, und
daß entweder mit den Anschlüsse des Differenzeingangs oder mit dem Steuereingang des Kompensatios-Differenzverstärkers (15) eine Widerstandsanordnung (18, 20, 21) gekoppelt ist.

2. Integrierte Schaltungsanordnung nach Anspruch 1,
dadurch gekennzeichnet, daß zwischen dem Steuereingang des Kompensations-Differenzverstärkers (15) und dem zweiten Bezugspotential eine Widerstandsanordnung (21) angeordnet ist, daß mit den Anschlüssen des Differenzeingangs des Kompensations-Differenzverstärkers (15) Anschlüsse eines ersten und zweiten Widerstandes (18, 20) gekoppelt sind, daß der andere Anschluß des ersten Widerstandes (18) an dem ersten Bezugspotential liegt und daß der andere Anschluß des zweiten Widerstandes (20) mit einem dritten Bezugspotential gekoppelt ist.

3. Integrierte Schaltungsanordnung nach Anspruch 1 oder 2,
dadurch gekennzeichnet, daß die Widerstandsanordnung einen dritten Widerstand (21) enthält.

4. Integrierte Schaltungsanordnung nach Anspruch 2,
dadurch gekennzeichnet, daß der erste und/oder der zweite Widerstand (18, 20) eine vorbestimmte Temperaturabhängigkeit aufweisen.

5. Integrierte Schaltungsanordnung nach Anspruch 3,
dadurch gekennzeichnet, daß der dritte Widerstand (21) eine vorbestimmte Temperaturabhängigkeit aufweist.

6. Integrierte Schaltungsanordnung nach einem der vorhergehenden Ansprüche,
dadurch gekennzeichnet, daß in Reihe zu jedem als Impedanzwandler geschalteten Transistor (6, 8) wenigstens ein weiterer als Impedanzwandler geschalteter Transistor (9, 10) angeordnet ist.

7. Integrierte Schaltungsanordnung nach Anspruch 2 und 6,
dadurch gekennzeichnet, daß zwischen dem zweiten Widerstand (20) und den Anschlüssen des Differenzeingangs des Kompensations-Differenzverstärkers (15) wenigstens eine Diodenanordnung (19) geschaltet ist.

8. Integrierte Schaltungsanordnung nach Anspruch 7,
dadurch gekennzeichnet, daß die Diodenanordnung (19) einen als Diode geschalteten Transistor enthält.

9. Integrierte Schaltungsanordnung nach einem der vorhergehenden Ansprüche,
dadurch gekennzeichnet, daß die Transistoren (16, 17) des Kompensations-Differenzverstärkers (15) andere geometrische Abmessungen als die als Impedanzwandler geschalteten Transistoren (6, 8, 9, 10) aufweisen.

10. Integrierte Schaltungsanordnung nach einem der vorhergehenden Ansprüche,
dadurch gekennzeichnet, daß jede Arbeitswiderstandsanordnung (5, 7) aus einem vierten und fünften Widerstand (22, 23, 24, 25) besteht, die in Reihe geschaltet sind und an deren gemeinsamen Verbindungspunkt die Ausgänge des Kompensations-Differenzverstärkers (15) angeschlossen sind.

## Claims

1. An integrated circuit arrangement including a differential amplifier (1) which comprises a differential input (Vₑ₁, Vₑ₂) and a control input, and the outputs of which are coupled to a load resistor arrangement (5, 7) and to a transistor (6, 8) arranged as an impedance transformer, and the control input of which is coupled to a current source (4), characterized in that a compensation differential amplifier (15) for superimposing its output currents on each output current of the differential amplifier (1) is provided for compensating voltage variations in each load resistor arrangement (5, 7) at a change of temperature, in that the terminals of the differential input of the compensation differential amplifier (15) are coupled to a first reference potential, and the control input of the compensation differential amplifier (15) is coupled to a second reference potential to evenly distribute the current supplied to the control input of the compensation differential amplifier (15) among the outputs of said compensation differential amplifier, and in that a resistor arrangement (18, 20, 21) is coupled either to the terminals of the differential input or to the control input of the compensation differential amplifier (15).

2. An integrated circuit arrangement as claimed in Claim 1, characterized in that a resistor arrangement (21) is arranged between the control input of the compensation differential amplifier (15) and the second reference potential, in that terminals of a first and a second resistor (18, 20) are coupled to the terminal of the differential input of the compensation differential amplifier (15), in that the other terminal of the first resistor (18) is coupled to the first reference potential and in that the other terminal of the second resistor (20) is coupled to a third reference potential.

3. An integrated circuit arrangement as claimed in Claim 1 or 2, characterized in that the resistor arrangement includes a third resistor (21).

4. An integrated circuit arrangement as claimed in Claim 2, characterized in that the first and/or the second resistor (18, 20) have a predetermined temperature dependence.

5. An integrated circuit arrangement as claimed in Claim 3, characterized in that the third resistor (21) has a predetermined temperature dependence.

6. An integrated circuit arrangement as claimed in any one of the preceding Claims, characterized in that at least one further transistor (9, 10) arranged as an impedance transformer is connected in series with each transistor (6, 8) arranged as an impedance transformer.

7. An integrated circuit arrangement as claimed in Claims 2 and 6, characterized in that at least one diode arrangement (19) is connected between the second resistor (20) and the terminals of the differential input of the compensation differential amplifier (15).

8. An integrated circuit arrangement as claimed in Claim 7, characterized in that the diode arrangement (19) includes a transistor arranged as a diode.

9. An integrated circuit arrangement as claimed in any one of the preceding Claims, characterized in that the transistors (16, 17) of the compensation differential amplifier (15) have different geometrical dimensions than the transistors (6, 8, 9, 10) arranged as impedance transformers.

10. An integrated circuit arrangement as claimed in any one of the preceding Claims, characterized in that each load resistor arrangement (5, 7) includes a fourth and a fifth resistor (22, 23, 24, 25) which are arranged in series and have their common junction points connected to the outputs of the compensation differential amplifier (15).

## Revendications

1. Dispositif à circuit intégré avec amplificateur différentiel (1) qui a une entrée différentielle (Ue1, Ue2) et une entrée de commande, dont les sorties sont respectivement reliées à un dispositif à résistance de charge (5, 7) et respectivement à un transistor monté comme un adaptateur d'impédance (6,8) et leur entrée de commande à une source de courant (4),
caractérisé en ce
qu'un amplificateur différentiel de compensation (15) est prévu pour la superposition de ses courants de sortie avec les courants de sortie respectifs de l'amplificateur différentiel (1) en vue de la compensation des variations de tension dans les dispositifs respectifs à résistance de charge (5, 7) en cas de variation de température,
en ce que les connexions de l'entrée différentielle de l'amplificateur différentiel de compensation (15) sont respectivement raccordées à un premier potentiel de référence et l'entrée de commande de l'amplificateur différentiel de compensation (15) à un deuxième potentiel de référence pour la répartition régulière du courant amené à l'entrée de commande de l'amplificateur différentiel de compensation (15) sur les sorties de l'amplificateur différentiel de compensation, et
en ce qu'un dispositif à résistance (18, 20, 21) est couplé soit aux connexions de l'entrée différentielle ou à l'entrée de commande de l'amplificateur différentiel de compensation (15).

2. Dispositif à circuit intégré selon la revendication 1,
caractérisé en ce
qu'entre l'entrée de commande de l'amplificateur différentiel de compensation (15) et le deuxième potentiel de référence est disposé un dispositif à résistance (21), qu'avec les connexions de l'entrée différentielle de l'amplificateur différentiel de compensation (15) sont raccordées les connexions d'une première et d'une deuxième résistance (18, 20), que l'autre connexion de la première résistance (18) est appliquée au premier potentiel de référence et que l'autre connexion de la deuxième résistance (20) est raccordée à un troisième potentiel de référence.

3. Dispositif à circuit intégré selon l'une des revendications 1 ou 2,
caractérisé en ce
que le dispositif à résistance contient une troisième résistance (21).

4. Dispositif à circuit intégré selon la revendication 2,
caractérisé en ce
que la première et/ou la deuxième résistance (18, 20) présentent une variabilité prédéterminée avec la température.

5. Dispositif à circuit intégré selon la revendication 3,
caractérisé en ce
que la troisième résistance (21) présente une variabilité prédéterminée avec la température.

6. Dispositif à circuit intégré selon l'une des revendications précédentes,
caractérisé en ce
qu'au moins un autre transistor (9, 10) monté en série comme adaptateur d'impédance est disposé en série avec chaque transistor (6, 8) monté comme adaptateur d'impédance.

7. Dispositif à circuit intégré selon l'une des revendications 2 et 6,
caractérisé en ce
qu'au moins un dispositif à diodes (19) est monté entre la deuxième résistance (20) et les connexions de l'entrée différentielle de l'amplificateur différentiel de compensation (15).

8. Dispositif à circuit intégré selon la revendication 7,
caractérisé en ce
que le dispositif à diodes (19) contient un transistor monté comme une diode.

9. Dispositif à circuit intégré selon l'une des revendications précédentes,
caractérisé en ce
que les transistors (16, 17) de l'amplificateur différentiel de compensation (15) présentent d'autres dimensions géométriques que les transistors (6, 8, 9, 10) montés comme des adaptateurs d'impédance.

10. Dispositif à circuit intégré selon l'une des revendications précédentes,
caractérisé en ce
que chaque dispositif à résistance de charge (5, 7) se compose d'une quatrième et d'une cinquième résistance (22, 23, 24, 25) qui sont montées en série et sont raccordées à leur point de liaison commun aux sorties de l'amplificateur différentiel de compensation (15).
